# EUROPÄISCHE PATENTSCHRIFT

(11) **EP 0 447 845 B1**
(45) Veröffentlichungstag und Bekanntmachung des Hinweises auf die Patenterteilung: **03.05.1995**
(21) Anmeldenummer: 91102907.2
(22) Anmeldetag: 28.02.1991
(51) Int. Cl.: C07D 251/34, G03F 7/027

(54) **Strahlungshärtbare Amin- und Harnstoffgruppen enthaltende Urethanacrylatverbindungen**
Radiation curable amine- and ureagroups containing urethane acrylate compounds
Composés uréthane acrylate durcissables par de l'irradiation contenant des groupes amine et urée

(30) Priorität: 07.03.1990 DE 4007146
(43) Veröffentlichungstag der Anmeldung: 25.09.1991
(73) Patentinhaber: BASF Aktiengesellschaft, 67063 Ludwigshafen (DE)
(72) Erfinder: Beck, Erich, Dr., W-6721 Harthausen (DE); Weiss, Wolfram, Dr., W-6704 Mutterstadt (DE); Renz, Hans, Dr., W-6701 Meckenheim (DE); Lindner, Alfred, Dr., W-6712 Bobenheim-Roxheim (DE)

(56) Entgegenhaltungen:
- EP-A- 0 167 731
- DE-A- 2 140 306
- DE-A- 3 106 367
- US-A- 4 145 544
- US-A- 4 159 376

## Beschreibung

Die vorliegende Erfindung betrifft strahlungshärtbare Amin- und Harnstoffgruppen enthaltende Urethanacrylatverbindungen auf der Basis von Di- oder Polyisocyanaten, Hydroxyverbindungen und Aminen, erhältlich durch Umsetzung von Di- oder Polyisocyanaten mit Hydroxyverbindungen in einem ersten Schritt und anschließende Umsetzung der Reaktionsprodukte mit primären oder sekundären Aminen, in einem zweiten Schritt, dadurch gekennzeichnet, daß
a) im ersten Schritt Isocyanatgruppen und Hydroxygruppen im molaren Verhältnis 1 : 0,55 bis 1 : 0,99 umgesetzt werden und mindestens 20 mol-% der Hydroxygruppen enthaltenden Verbindungen Hydroxyacrylate sind, und
b) im zweiten Schritt die primären oder sekundären Amine im molaren Überschuß, bezogen auf die nach dem ersten Schritt noch vorhandenen Isocyanatgruppen eingesetzt werden und der molare Überschuß geringer ist als die molare Menge der im ersten Schritt eingesetzten Hydroxyacrylate.

Urethanacrylatverbindungen dienen, gegebenenfalls in Kombination mit weiteren strahlungshärtbaren Komponenten, als Massen und Beschichtungen, welche in Gegenwart eines Photoinitiatorsystems mittels energiereicher Strahlung gehärtet werden können.

Aus der DE-A-31 06 367 sind alkenungesättigte Oligourethanverbindungen bekannt, die durch Umsetzung von Di- oder Poliisocyanaten mit Polyolen, alkenungesättigten Hydroxylverbindungen, wobei es sich um Methacrylsäureester handelt, und N,N'-substituierten aliphatischen Aminen erhalten werden. Der Aminzusatz dient zur schnellen Abreaktion restlicher Isocyanatendgruppen zu Harnstoffendgruppen, um lagerstabile Produkte zu erhalten. Überschüssiges Amin liegt unter den gewählten Bedingungen als frei, ungebundene Komponente vor und führt im ungehärteten oder gehärteten Produkt durch Migration zu Ausschwitzungen und Emissionen sowie im gehärteten Produkt zu einer Weichmacherwirkung.

In der EP-B-167 731 wird der Abbau von Restisocyanat bei Urethanacrylaten, die aus Isophorondiisocyanat oder dessen Isocyanurat, Hydroxylalkylacrylaten und Polyhydroxyverbindungen hergestellt werden, durch Zusatz von primären oder sekundären Diaminen beschrieben. Diamine führen zu einer Kettenverlängerung und bei einem Überschuß an Diamin, bezogen auf die Isocyanatgruppen, zu vernetzten Produkten.

In der DE-B-21 40 306 werden photopolymerisierbare Gemische beschrieben, die ein Polyurethan enthalten. Durch Aminverbindungen, welche sowohl in freier, gelöster Form vorliegen, als auch an Isocyanatgruppen gebunden sein können, wird bei Anwesenheit von Luftsauerstoff eine schnelle Härtungszeit erreicht. Bei der Synthese der aminmodifizierten Polyurethane werden primäre oder sekundäre Amine sowie tertiäre hydroxygruppenhaltige Amine eingesetzt, wobei ein Überschuß dieser Amine, bezogen auf die Restisocyanatgruppen, sorgfältig vermieden wird, d.h. es ist auf eine sorgfältige molare Äquivalenz zu achten.

Insgesamt ergibt sich aus dem Stand der Technik ein Wunsch nach möglichst reaktiven Urethanacrylatverbindungen, die auf einfachem Wege herstellbar sind. Emissionen von frei migrierbaren Hydroxyverbindungen oder Aminen bei der Verwendung der Urethanacrylatverbindungen als Überzugsmasse oder Formmasse sollen nicht auftreten.

Der Erfindung lag daher die Aufgabe zugrunde, strahlungshärtbare Urethanacrylatverbindungen mit hoher Reaktivität sowie ein Verfahren zu deren Herstellung zur Verfügung zu stellen.

Demgemäß wurden die strahlungshärtbaren Amin- und Harnstoffgruppen enthaltenden Urethanacrylatverbindungen gemäß Anspruch 1 gefunden. Weiterhin wurde ein Verfahren zur Herstellung der erfindungsgemäßen Urethanacrylatverbindungen gefunden.

Die erfindungsgemäßen Urethanacrylatverbindungen zeichnen sich überraschenderweise durch ein insgesamt vorteilhaftes Eigenschaftsspektrum aus, insbesondere hinsichtlich Reaktivität und Gehalt an frei migrierbaren Verbindungen.

Das erfindungsgemäße Verfahren zur Herstellung der Urethanacrylatverbindungen führt zu Urethanacrylatverbindunbgen, die weitgehend frei von freien Isocyanatgruppen und ungebunden vorliegenden Hydroxyalkylacrylaten oder Aminen sind. Unerwünschte Emissionen toxischer Amine oder Hydroxyalkylacrylate können daher weitgehend vermieden werden.

Als Di- oder Polyisocyanatverbindungen, welche den erfindungsgemäßen Urethanacrylatverbindungen zugrunde liegen, sind Verbindungen geeignet, die mindestens zwei zur Reaktion mit Alkoholen oder primären und sekundären Aminen befähigte Isocyanatgruppen enthalten. Neben aliphatischen, cycloaliphatischen und aromatischen Diisocyanaten handelt es sich dabei auch um Polyisocyanate, z.B. Isocyanurate, Polyisocyanate, die Biuretgruppen enthalten, und Polyisocyanate, wie sie bei der Umsetzung von mindestens dreiwertigen Alkoholen mit Diisocyanaten entstehen.

Bevorzugt sind Isophorondiisocyanat, Hexamethylendiisocyanat, Trimethylhexamethylendiisocyanate, Toluylendiisocyanate, Diphenylmethandiisocyanate, Dicyclohexylen-4,4'-diisocyanate, Xylenyldiisocyanate.

Besonders bevorzugt sind Umsetzungsprodukte aus mindestens dreiwertigen Alkoholen mit mindestens einer Diisocyanatverbindung im OH/NCO-Äquivalenzverhältnis von 1:1,5 bis 1:3, vorzugsweise 1:1,5 bis 1:2,5 oder Isocyanurate als Polyisocyanate.

Ganz besonders bevorzugt ist das Isocyanurat des Hexamethylendiamins.

Die erfindungsgemäßen Urethanacrylatverbindungen enthalten Hydroxyverbindungen, welche über die Isocyanatgruppen gebunden sind.

Mindestens 20, insbesondere mindestens 50 und besonders bevorzugt mindestens 70 mol.% der Hydroxyverbindungen sind Hydroxyacrylate.

Als Hydroxyacrylate in Frage kommen z.B. Mono-, Di- oder Triacrylate wie sie z.B. durch Umsetzung von Acrylsäure mit ein- oder mehrwertigen Alkoholen bzw. deren alkoxylierten Derivaten sowie durch Umsetzung von Acrylsäure mit Mono- oder Diepoxiverbindungen entstehen.

Bevorzugt sind Hydroxyacrylate der allgemeinen Formel 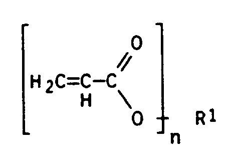
wobei es sich bei R¹ um einen durch ein oder zwei Hydroxylgruppen substituierten C₂-C₈-Alkylrest handelt und n = 1, 2 oder 3 ist, z.B. 2-Hydroxyethylacrylat, 3-Hydroxypropylacrylat, Butandiolmonoacrylat, Trimethylolpropanmonoacrylat, Trimethylolpropandiacrylat und Pentaerythrittriacrylat oder deren Mischungen.

Ebenfalls bevorzugt werden eingesetzt: Phenylglycidetheracrylat, Kresylglycidetheracrylat, Versaticsäureglycidesteracrylat, Butandioldiglycidetherdiacrylat undf Bisphenol-A-Diglycidetherdiacrylat. Es können auch Mischungen der Hydroxyacrylate eingesetzt werden.

Die erfindungsgemäßen Urethanacrylatverbindungen enthalten über Hydroxygruppen an Isocyanat gebundene, durch Additionsreaktion von primären oder sekundären Aminen an Hydroxyacrylate erhältliche sekundäre oder tertiäre Aminogruppen. Primäre oder sekundäre Aminogruppen reagieren mit Hydroxyacrylaten in einer Michael-analogen Reaktion nach 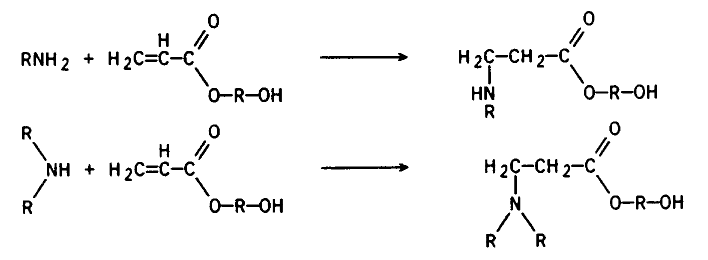
Die erfindungsgemäßen Urethanacrylatverbindungen enthalten bevorzugt 0,01 bis 0,60 Mol, besonders bevorzugt 0,1 bis 0,3 Mol der so erhältlichen sekundären oder tertiären Aminogruppen und bevorzugt 0,01 bis 0,30 Mol, besonders bevorzugt 0,05 bis 0,20 Mol Harnstoffgruppen, bezogen auf 1 Mol Isocyanatgruppen der für die Herstellung der Urethanacrylatverbindungen eingesetzten Di- oder Polyisocyanate.

Als primäre oder sekundäre Amine, welche sich in einer Michael-analogen Reaktion an Hydroxyacrylate addieren, kommen z.B. heterocyclische Verbindungen wie Piperazin, 1-Ethylpiperazin, N-(Aminoethyl)-imidazol, Morpholin, N-(Aminoethyl)-morpholin sowie primäre oder sekundäre Amine, die durch aliphatische und/oder aromatische Gruppen substituiert sind, in Frage. Bevorzugt sind aliphatische primäre oder sekundäre Amine, die durch eine oder zwei C₁-C₆-Alkylgruppen oder C₁-C₆-Hydroxylalkylgruppen substituiert sind. Besonders bevorzugt sind primäre oder sekundäre Amine, die durch eine oder zwei C₁-C₄-Alkylgruppen substituiert sind. Ganz besonders bevorzugt sind Dibutylamin und Morpholin. Die genannten primären und sekundären Amine führen bei direkter Umsetzung mit Isocyanatgruppen zu Harnstoffgruppen. Die Harnstoffgruppen im erfindungsgemäßen Urethanacrylat enthalten bevorzugt die gleichen Aminogruppen wie sie auch im Michael-Additionsprodukt aus Hydroxyacrylat und Amin vorliegen. Für die bevorzugte bzw. besonders bevorzugte Auswahl der Aminogruppen gilt das bereits vorstehend Gesagte.

Das erfindungsgemäße Verfahren zur Herstellung von strahlungshärtbaren Amin- und Harnstoffgruppen enthaltenden Urethanacrylatverbindungen durch Umsetzung von Di- oder Polyisocyanaten mit Hydroxyverbindungen in einem ersten Schritt und anschließende Umsetzung der Reaktionsprodukte mit primären oder sekundären Aminen in einem zweiten Schritt ist dadurch gekennzeichnet, daß
a) im ersten Schritt Isocyanatgruppen und Hydroxygruppen im molaren Verhältnis 1:0,55 bis 1:0,99 umgesetzt werden und mindestens 20 mol-% der Hydroxygruppen enthaltenden Verbindungen Hydroxyacrylate sind, und
b) im zweiten Schritt die primären oder sekundären Amine im molaren Überschuß, bezogen auf die nach dem ersten Schritt noch vorhandenen Isocyanatgruppen, eingesetzt werden und der molare Überschuß geringer ist als die molare Menge der im ersten Schritt eingesetzten Hydroxyacrylate.

Bevorzugt werden im ersten Schritt a) 0,70 bis 0,99 mol Hydroxygruppen, besonders bevorzugt 0,8 bis 0,95 mol bezogen auf 1 mol Isocyanatgruppen, eingesetzt. Mindestens 20, bevorzugt mindestens 50, besonders bevorzugt mindestens 70 mol-% der im ersten Schritt a) eingesetzten Hydroxyverbindungen sind Hydroxyacrylate.

Bevorzugt, besonders bevorzugt und ganz besonders bevorzugt eingesetzte Hydroxyacrylate und Di- oder Polyisocyanate können den vorangegangenen Aufzählungen über bevorzugt, besonders bevorzugt und ganz besonders bevorzugt in den Urethanacrylatverbindungen enthaltene Hydroxyacrylate und Di- oder Polyisocyanate entnommen werden.

Die Umsetzung der Di- oder Polyisocyanatverbindungen mit den Hydroxyverbindungen erfolgt nach an sich bekannten und in der Literatur beschriebenen Verfahren.

Die Reaktionstemperatur für die Umsetzung der Di- oder Polyisocyanate mit den Hydroxyverbindungen kann bevorzugt zwischen 0 und 100°C, insbesondere zwischen 20 und 70°C liegen.

Zur Beschleunigung der Umsetzung können Katalysatoren, wie sie z.B. in Houben Weyl, Methoden der organischen Chemie, Bd. XIV/2, S. 60f, Georg Thieme-Verlag, Stuttgart (1963) bzw. Ullmann, Encyclopädie der technischen Chemie, Bd. 19, S. 306 (1981) beschrieben sind, eingesetzt werden. Bevorzugt sind zinnhaltige Verbindungen wie Dibutylzinndilaurat, Zinn(II)octoat oder Dibutylzinndimethoxid.

Im allgemeinen werden solche Katalysatoren in einer Menge von 0,001 bis 2,5 Gew.-%, bevorzugt von 0,005 bis 1,5 Gew.-%, bezogen auf die Gesamtmenge der Reaktanden eingesetzt.

Zur Stabilisierung der radikalisch polymerisierbaren Verbindungen werden vorzugsweise 0,001 bis 2 Gew.-%, insbesondere 0,005 bis 1,0 % Polymerisationsinhibitoren zugesetzt. Dabei handelt es sich um die üblichen, zur Verhinderung einer radikalischen Polymerisation verwendeten Verbindungen, z.B. vom Typ des Hydrochinons, der Hydrochinonmonoalkylether, des 2,6-Di-t-butylphenols, der N-Nitrosoamine, der Phenothiazine oder Phosphorigsäureester.

Die Reaktion kann lösungsmittelfrei oder auch unter Zusatz von Lösungsmitteln durchgeführt werden. Als Lösungsmittel kommen sowohl inerte Lösungsmittel als auch Monomere, die bei der Photopolymerisation mit dem Urethanacrylat copolymerisieren, in Frage.

Als inerte Lösungsmittel finden z.B. Aceton, Tetrahydrofuran, Dichlormethan, Toluol etc. Verwendung, bevorzugt werden Methylethyketon, Essigester und Butylacetat eingesetzt.

Als Monomere können z.B. Acrylate, Methacrylate olefinisch ungesättigte Aromaten etc. verwendet werden. Bevorzugt sind niedrigviskose, geruchsarme Acrylesterverbindungen wie Hexandioldiacrylat, Trimethylolpropantriacrylat und Acrylsäureester, wie sie bei der Umsetzung von Acrylsäure mit Tripropylenglykol, Glycerin, Pentaerythrit und Trimethylolpropan entstehen. Ebenfalls bevorzugt sind Acrylsäureester bzw. -estergemische eines mit der 2- bis 10-fachen molaren Menge Ethylenoxid, Propylenoxid oder eines Gemisches beider Epoxide umgesetzten Trimethylolpropans.

Die Reaktionsbedingungen werden solange beibehalten bis sichergestellt ist, daß alle eingesetzten Hydroxyverbindungen mit den Isocyanatgruppen reagiert haben und die Reaktionslösung frei von Hydroxyverbindungen ist.

Erst dann werden den im Verfahrensschritt a) entstandenen Verbindungen im verfahrensschritt b) primäre oder sekundäre Amine oder Mischungen dieser Amine zugesetzt, wobei die Amine, bezogen auf die nach Verfahrensschritt a) noch vorhandenen Isocyanatgruppen im molaren Überschuß eingesetzt werden und der molare Überschuß der Amine geringer ist als die molare Menge der in Schritt a) eingesetzten Hydroxyacrylate. Der Einsatz der Amine im Überschuß bezogen auf die nach Verfahrensschritt a) noch vorhandenen Isocyanatgruppen bewirkt eine schnelle und völlige Umsetzung dieser Isocyanatgruppen zu Harnstoffgruppen. Das entstandene Polyurethan ist dadurch frei von Isocyanatendgruppen, wodurch eine gute Lagerstabilität bewirkt wird. Die überschüssigen primären und sekundären Amine liegen bezogen auf die im Polyurethan enthaltenen Hydroxyacrylatgruppen im molaren Unterschuß vor. Die primären und sekundären Amine addieren sich an die Hydroxyacrylatgruppen in Form einer Michaeladdition, wobei aus Acrylestergruppen Aminopropylestergruppen entstehen. Die Reaktion der primären und sekundären Amine mit Acrylsäureestern ist an sich bekannt und in Lehrbüchern der organischen Chemie beschrieben. Durch den Einsatz eines Unterschußes der primären oder sekundären Amine, bezogen auf die in Verfahrensschritt a) eingesetzten Hydroxyacrylate wird daher bewirkt, daß letztlich alle primären oder sekundären Amine an das Polyurethan gebunden sind und keine freien Amine in der Reaktionslösung vorliegen. Emissionen von Aminen bei der Verwendung des Polyacrylats bzw. seiner Lösung für Überzüge treten daher nicht auf. Die in dieser Weise gebundenen Amine bewirken einen deutlichen Anstieg der Reaktivität der Urethanacrylatverbindungen.

In Verfahrensschritt b) bevorzugt bzw. besonders bevorzugt eingesetzte Amine können der vorangegangenen Aufzählung über bevorzugte in den Urethanacrylatverbindungen vorliegend Amine entnommen werden. Bevorzugt werden in Verfahrensschritt b) 0,02 bis 0,9, besonders bevorzugt 0,15 bis 0,50 mol-% Aminverbindungen, bezogen auf die vor Durchführung von Verfahrensschritt a) vorhandenen Isocyanatgruppen eingesetzt.

Die erhaltenen strahlungshärtbaren Urethanacrylatverbindungen können in strahlungshärtbaren Massen und Beschichtungen verwendet werden. Den Urethanacrylatverbindungen bzw. der erhaltenen Lösung von Urethanacrylatverbindungen werden zur Verarbeitung im allgemeinen weitere strahlungshärtbare Harze und Reaktivverdünner, d.h. radikalisch polymerisierbare Monomere zugesetzt. Die Urethanacrylatverbindungen können auch mit Emulgierhilfsmitteln in Wasser emulgiert werden. Hilfsstoffe wie Pigmente, Füllstoffe, Verlaufshilfsmittel und Stabilisatoren können gegebenenfalls zugesetzt werden. Den erfindungsgemäß hergestellten Urethanacrylatverbindungen bzw. deren Lösungen oder Gemische, welche weitere strahlungshärtbare Harze und Monomere enthalten können, werden bei der Anwendung Fotoinitiatoren zugesetzt, so daß nach Auftragen der Überzüge auf die entsprechenden Oberflächen die Aushärtung durch UV- oder Elektronenstrahlen erfolgen kann.

### Beispiel 1

Zu 571.8 g der Isocyanuratverbindung des Hexamethylendiisocyanats (Basonat ® P LR 8638, BASF AG) wurden 0,2 g Dibutylzinndilaurat, 1,0 g 2,6-Di-tertiär-butyl-p-kresol und 0,51 g Hydrochinonmonomethylether unter Rühren zugesetzt und auf 55°C erhitzt. Innerhalb von 89 Minuten wurden dann 396,7 g (2,75 Mol) Butandiolmonoacrylat zudosiert, wobei die Temperatur auf 70°C anstieg. Nach 4-stündiger Reaktion bei 70°C betrug der Isocyanatgehalt 0,165 Mol NCO. Es wurden dann innerhalb von 12 Minuten 94,9 g (0,735 Mol) Dibutylamin zugesetzt, die Temperatur stieg dabei auf 73°C. Nach weiteren 2,5 Stunden wurde mit 424 Teilen Dipropylenglykoldiacrylat auf 4,96 Pa*s (23°C, ICI-Kegelplatte-Viskosimeter) verdünnt.

Um auf eine Verarbeitungsviskosität von 500 mPa*s zu kommen, wurden 100 g der erhaltenen Mischung mit Butylacetat weiter verdünnt und als Fotoinitiator 4 g Benzildimethylketal (Lucirin ® BDK, BASF) zugesetzt. Eine auf 15 um Naßfilmstärke aufgetragene Schicht auf KD-Papier wurde nach dem Ablüften des Lösungsmittels zur Bestimmung der Reaktivität im Abstand von 10 cm an Luft unter einer 80 W/cm Quecksilbermitteldrucklampe mittels eines Transportbandes vorbeigeführt. Dabei wurde bei einer Bandgeschwindigkeit von 50 m/min ein kratzfester Überzug erhalten. Entsprechend wurde eine 100 um-Schicht ebenfalls bei 50 m/min kratzfest. Eine 200 um-Schicht auf Glas, zweimal mit je 10 m/min Bandgeschwindigkeit belichtet, hat eine Pendeldämpfung von 42 sec (DIN 53157). Eine gleich belichtete 50 um-Schicht auf BONDER-Blech 132 erreichte einen Erichsentiefungswert von 6,2 mm (DIN 53156). Die Chemikalienbeständigkeiten (DIN 68860B) waren sehr gut.

Die Aminzahl der Urethanacrylatverbindung betrug 30,4 (mgKOH/g). Es handelt sich dabei um Amine, welche sich in einer Michael-analogen Reaktion an Hydroxyacrylat addiert haben und so über die Hydroxygruppe des Acrylats an das Urethanacrylat gebunden sind.

### Beispiel 2

Zu 508,7 g der Isocyanuratverbindung des Toluylendiisocyanat (Basonat ® P LR 8528, BASF AG), wurden 0,18 g Dibutylzinndilaurat, 0,9 g 2,6-Di-tertiär-butyl-p-kresol und 0,45 g Hydrochinonmonomethylether unter Rühren zugesetzt. Innerhalb von 52 Minuten wurden dann 292,3 g (2,03 Mol) Butandiolmonoacrylat zudosiert, wobei die Temperatur auf 70°C anstieg. Nach 6-stündiger Reaktion bei 70°C betrug der Isocyanatgehalt 0,067 Mol. Es wurden dann innerhalb von 31 Minuten 99,3 g (0,77 Mol) Dibutylamin zugesetzt, die Temperatur stieg dabei auf 75°C. Nach weiteren 2 Stunden verdünnte man mit 360,7 g Dipropylenglykoldiacrylat auf 241 Pa*s (23°C, ICI-Kegelplatte-Viskosimeter).

Um auf eine Verarbeitungsviskosität von 500 mPa*s zu kommen, wurden 100 g der erhaltenen Mischung mit Butylacetat verdünnt und als Fotoinitiator 4 g Benzildimethylketal (Lucirin ® BDK, BASF) zugesetzt. Eine auf 15 um Naßfilmstärke aufgetragene Schicht auf KD-Papier wurde nach dem Ablüften des Lösungsmittels zur Bestimmung der Reaktivität im Abstand von 10 cm an Luft unter einer 80 W/cm Quecksilbermitteldrucklampe mittels eines Transportbandes vorbeigeführt. Dabei wurde bei einer Bandgeschwindigkeit von 55 m/min ein kratzfester Überzug erhalten. Entsprechend wurde eine 100 um-Schicht bei 60 m/min kratzfest. Eine 200 um-Schicht auf Glas, zweimal mit je 10 m/min Bandgeschwindigkeit belichtet, hat eine Pendeldämpfung von 55 sec (DIN 53157). Eine gleich belichtete 50 um-Schicht auf BONDER-Blech 132 erreichte einen Erichsentiefungswert von 7,2 mm (DIN 53156). Die Chemikalienbeständigkeiten (DIN 68860B) waren excellent. Die Aminzahl des Urethanacrylats betrug 45,5.

### Vergleichsbeispiel

Im Gegensatz zu den Beispielen wurden zu Isocyanat äquivalente Mengen an Hydroxyalkylacrylat und Amin zugesetzt.

Zu 601,9 g der Isocyanuratverbindung des Hexamethylendiisocyanat, wurden 0,2 g Dibutylzinndilaurat, 1,0 g 2,6-Di-tertiär-butyl-p-kresol und 0,51 g Hydrochinonmonomethylether unter Rühren zugesetzt und auf 55°C erhitzt. Innerhalb von 50 Minuten wurden dann 326,6 g (2,27 Mol) Butandiolmonoacrylat zudosiert, wobei die Temperatur auf 70°C ansteigt. Nach 2-stündiger Reaktion bei 70°C beträgt der Isocyanatgehalt 0,78 Mol NCO. Es wurden dann innerhalb von 50 Minuten 101,3 g (0,78 Mol) Dibutylamin zugesetzt, die Temperatur stieg dabei auf 73°C. Nach weiteren 2,5 Stunden wurde mit 412,6 g Dipropylenglykoldiacrylat auf 7,8 Pa*s (23°C, ICI-Kegelplatte-Viskosimeter) verdünnt. Die Aminzahl des Urethanacrylats betrug 0,1.

Nach Einstellung der Verarbeitungsviskosität und dem Zusatz von 4 g Benzildimethylketal wurden die Reaktivitäten, die Pendeldämpfung und der Erichsentiefenwert analog zu den Beispielen bestimmt.

Es wurden Reaktivitäten von jeweils nur 10 m/min für die 15 um- und 100 um-Schicht erreicht. Die Pendeldämpfung betrug 70 sec und die Erichsentiefung 5,6 mm. Die Chemikalienbeständigkeit ist vergleichbar zum Beispiel 1.

Die Versuche zeigen, daß bei Einsatz eines Überschußes einer Aminverbindung, bezogen auf die nach Umsetzung mit dem Hydroxyacrylat noch vorhandenen Isocyanatäquivalente ein deutlich höheres Eigenschaftsniveau erreicht wird. Das überschüssige Amin liegt unter den Versuchsbedingungen nicht als freie Verbindung vor, sondern ist an die mit Isocyanat umgesetzten Hydroxyacrylate gebunden.

## Patentansprüche (Patentansprüche für folgende(n) Vertragsstaat(en): AT, BE, CH, DE, DK, FR, GB, IT, LI, NL, SE)

1. Strahlungshärtbare Amin- und Harnstoffgruppen enthaltende Urethanacrylatverbindungen auf der Basis von Di- oder Polyisocyanaten, Hydroxyverbindungen und Aminen, erhältlich durch Umsetzung von Di- oder Polyisocyanaten mit Hydroxyverbindungen in einem ersten Schritt und anschließend Umsetzung der Reaktionsprodukte mit primären oder sekundären Aminen, in einem zweiten Schritt, dadurch gekennzeichnet, daß
a) im ersten Schritt Isocyanatgruppen und Hydroxygruppen im molaren Verhältnis 1 : 0,55 bis 1 : 0,99 umgesetzt werden und mindestens 20 mol-% der Hydroxygruppen enthaltenden Verbindungen Hydroxyacrylate sind, und
b) im zweiten Schritt die primären oder sekundären Amine im molaren Überschuß, bezogen auf die nach dem ersten Schritt noch vorhandenen Isocyanatgruppen eingesetzt werden und der molare Überschuß geringer ist als die molare Menge der im ersten Schritt eingesetzten Hydroxyacrylate.

2. Urethanacrylatverbindungen gemäß Anspruch 1, enthaltend 0,01 bis 0,6 Mol der genannten sekundären oder tertiären Aminogruppen und 0,01 bis 0,30 Mol Harnstoffgruppen, bezogen auf 1 Mol Isocyanatgruppen der für die Herstellung der Urethanacrylatverbindungen eingesetzten Di- oder Polyisocyanate.

3. Urethanacrylatverbindungen gemäß einem der Ansprüche 1 oder 2, enthaltend Umsetzungsprodukte aus mindestens dreiwertigen Alkoholen mit mindestens einer Diisocyanatverbindung im OH/NCO Äquivalentverhältnis von 1 : 1,5 bis 1 : 2,5 als Polyisocyanate.

4. Urethanacrylatverbindungen gemäß mindestens einem der Ansprüche 1 bis 3, enthaltend Isocyanurate als Polyisocyanate.

5. Verfahren zur Herstellung von strahlungshärtbaren, Amin- und Harnstoffgruppen enthaltenden Urethanacrylatverbindungen durch Umsetzung von Di- oder Polyisocyanaten mit Hydroxyverbindungen in einem ersten Schritt und anschließende Umsetzung der Reaktionsprodukte mit primären oder sekundären Aminen, in einem zweiten Schritt, dadurch gekennzeichnet, daß
a) im ersten Schritt Isocyanatgruppen und Hydroxygruppen im molaren Verhältnis 1 : 0,55 bis 1 : 0,99 umgesetzt werden und mindestens 20 mol-% der Hydroxygruppen enthaltenden Verbindungen Hydroxyacrylate sind, und
b) im zweiten Schritt die primären oder sekundären Amine im molaren Überschuß, bezogen auf die nach dem ersten Schritt noch vorhandenen Isocyanatgruppen eingesetzt werden und der molare Überschuß geringer ist als die molare Menge der im ersten Schritt eingesetzten Hydroxyacrylate.

6. Verwendung der strahlungshärtbaren Urethanacrylatverbindungen gemäß Anspruch 1 in strahlungshärtbaren Massen mit Beschichtungen.

## Patentansprüche (Patentansprüche für folgende(n) Vertragsstaat(en): ES)

1. Verfahren zur Herstellung von strahlungshärtbaren, Amin- und Harnstoffgruppen enthaltenden Urethanacrylatverbindungen durch Umsetzung von Di- oder Polyisocyanaten mit Hydroxyverbindungen in einem ersten Schritt und anschließende Umsetzung der Reaktionsprodukte mit primären oder sekundären Aminen, in einem zweiten Schritt, dadurch gekennzeichnet, daß
a) im ersten Schritt Isocyanatgruppen und Hydroxygruppen im molaren Verhältnis 1 : 0,55 bis 1 : 0,99 umgesetzt werden und mindestens 20 mol-% der Hydroxygruppen enthaltenden Verbindungen Hydroxyacrylate sind, und
b) im zweiten Schritt die primären oder sekundären Amine im molaren Überschuß, bezogen auf die nach dem ersten Schritt noch vorhandenen Isocyanatgruppen eingesetzt werden und der molare Überschuß geringer ist als die molare Menge der im ersten Schritt eingesetzten Hydroxyacrylate.

2. Verfahren gemäß Anspruch 1, dadurch gekennzeichnet, daß die Urethanacrylatverbindungen 0,01 bis 0,6 Mol der genannten sekundären oder tertiären Aminogruppen und 0,01 bis 0,30 Mol Harnstoffgruppen, bezogen auf 1 Mol Isocyanatgruppen der für die Herstellung der Urethanacrylatverbindungen eingesetzten Di-oder Polyisocyanate enthalten.

3. Verfahren gemäß einem der Ansprüche 1 oder 2, dadurch gekennzeichnet, daß die Urethanacrylatverbindungen Umsetzungsprodukte aus mindestens dreiwertigen Alkoholen mit mindestens einer Diisocyanatverbindung im OH/NCO Äquivalentverhältnis von 1 : 1,5 bis 1 : 2,5 als Polyisocyanate enthalten.

4. Verfahren gemäß mindestens einem der Ansprüche 1 bis 3, dadurch gekennzeichnet, daß die Urethanacrylatverbindungen Isocyanurate als Polyisocyanate enthalten.

5. Verwendung der Strahlungshärtbaren Urethanacrylatverbindungen gemäß Anspruch 1 in Strahlungshärtbaren Massen mit Beschichtungen.

## Claims (Claims for the following Contracting State(s): AT, BE, CH, DE, DK, FR, GB, IT, LI, NL, SE)

1. A radiation-curable urethane acrylate compound containing amine and urea groups and based on di- or polyisocyanates, hydroxy compounds and amines, obtainable by reacting a di- or polyisocyanate with hydroxy compounds in a first step and then reacting the reaction product with a primary or secondary amine in a second step, wherein
a) in the first step isocyanate groups and hydroxyl groups are reacted in a molar ratio of from 1 : 0.55 to 1 : 0.99 and not less than 20 mol % of the hydroxyl-containing compounds are hydroxyacrylates, and
b) in the second step the primary or secondary amine is used in a molar excess, based on the isocyanate groups still present after the first step, and the molar excess is smaller than the molar amount of the hydroxyacrylates used in the first step.

2. A urethane acrylate compound as claimed in claim 1, containing from 0.01 to 0.6 mole of the stated secondary or tertiary amino groups and from 0.01 to 0.30 mole of urea groups per mole of isocyanate groups of the di- or polyisocyanates used for the preparation of the urethane acrylate compound.

3. A urethane acrylate compound as claimed in claim 1 or 2, containing a reaction product of a trihydric or polyhydric alcohol with one or more diisocyanate compounds in a ratio of the number of equivalents of OH to that of NCO of from 1 : 1.5 to 1 : 2.5, as a polyisocyanate.

4. A urethane acrylate compound as claimed in one or more of claims 1 to 3, containing an isocyanurate as the polyisocyanate.

5. A process for the preparation of a radiation-curable urethane acrylate compound containing amine and urea groups by reacting a di- or polyisocyanate with hydroxy compounds in a first step and then reacting the reaction product with a primary or secondary amine in a second step, wherein
a) in the first step isocyanate groups and hydroxyl groups are reacted in a molar ratio of from 1 : 0.55 to 1 : 0.99 and not less than 20 mol % of the hydroxyl-containing compounds are hydroxyacrylates, and
b) in the second step the primary or secondary amine is used in a molar excess, based on the isocyanate groups still present after the first step, and the molar excess is smaller than the molar amount of the hydroxyacrylates used in the first step.

6. Use of a radiation-curable urethane acrylate compound as claimed in claim 1 in radiation-curable materials and coatings.

## Claims (Claims for the following Contracting State(s): ES)

1. A process for the preparation of a radiation-curable urethane acrylate compound containing amine and urea groups by reacting a di- or polyisocyanate with hydroxy compounds in a first step and then reacting the reaction product with a primary or secondary amine in a second step, wherein
a) in the first step isocyanate groups and hydroxyl groups are reacted in a molar ratio of from 1 : 0.55 to 1 : 0.99 and not less than 20 mol % of the hydroxyl-containing compounds are hydroxyacrylates, and
b) in the second step the primary or secondary amine is used in a molar excess, based on the isocyanate groups still present after the first step, and the molar excess is smaller than the molar amount of the hydroxyacrylates used in the first step.

2. A process as claimed in claim 1, wherein the urethane acrylate compound contains from 0.01 to 0.6 mole of the stated secondary or tertiary amino groups and from 0.01 to 0.30 mole of urea groups per mole of isocyanate groups of the di- or polyisocyanates used for the preparation of the urethane acrylate compound.

3. A process as claimed in claim 1 or 2, wherein the urethane acrylate compound contains a reaction product of a trihydric or polyhydric alcohol with one or more diisocyanate compounds in a ratio of the number of equivalents of OH to that of NCO of from 1 : 1.5 to 1 : 2.5, as a polyisocyanate.

4. A process as claimed in any of claims 1 to 3, wherein the urethane acrylate compound contains an isocyanurate as the polyisocyanate.

5. Use of a radiation-curable urethane acrylate compound as claimed in claim 1 in radiation-curable materials and coatings.

## Revendications (Revendications pour l'(les) Etat(s) contractant(s) suivant(s): AT, BE, CH, DE, DK, FR, GB, IT, LI, NL, SE)

1. Composés d'acrylate d'uréthanne contenant des radicaux amine et urée, durcissables par des rayonnements, à base de diisocyanates ou de polyisocyanates, de composés hydroxylés et d'amines, que l'on peut obtenir par la réaction de diisocyanates ou de polyisocyanates avec des composés hydroxylés, au cours d'une première étape et par la réaction subséquente des produits de la réaction avec des amines primaires ou secondaires, au cours d'une seconde étape, caractérisé en ce que
(a) au cours de la première étape, on fait réagir les radicaux isocyanate et les radicaux hydroxyle dans le rapport molaire de 1:0,55 à 1:0,99 et au moins 20% molaires des composés contenant des radicaux hydroxyle sont des hydroxylacrylates et
(b) au cours de la seconde étape, on met en oeuvre les amines primaires ou secondaires en un excès molaire, par rapport aux radicaux isocyanate encore présents après la première étape et l'excès molaire est plus faible que la proportion molaire des hydroxylacrylates mis en oeuvre au cours de la première étape.

2. Composés d'acrylate d'uréthanne suivant la revendication 1, qui contiennent de 0,01 à 0,6 mode des radicaux amino secondaires ou tertiaires susmentionnés et 0,01 à 0,30 mode des radicaux urée, par rapport à 1 mode de radicaux isocyanates des diisocyanates ou des polyisocyanates mis en oeuvre pour la préparation des composés d'acrylate d'uréthanne.

3. Composés d'acrylate d'uréthanne suivant l'une quelconque des revendications 1 et 2, contenant des produits de réaction d'alcools au moins trihydroxylés avec au moins un composé de diisocyanate dans le rapport d'équivalence OH/NCO de 1:1,5 à 1:2,5, à titre de polyisocyanates.

4. Composés d'acrylate d'uréthanne suivant l'une quelconque des revendications 1 à 3, qui contiennent des isocyanurates à titre de polyisocyanates.

5. Procédé de préparation de composés d'acrylate d'uréthanne contenant des radicaux amine et urée, durcissables par des rayonnements, par la réaction de diisocyanates ou de polyisocyanates avec des composés hydroxylés au cours d'une première étape et réaction subséquente des produits de la réaction avec des amines primaires ou secondaires, au cours d'une seconde étape, caractérisé en ce que
(a) au cours de la première étape, on utilise les radicaux isocyanate et les radicaux hydroxyle dans le rapport molaire de 1:0,55 à 1:0,99 et au moins 20% molaires des composés contenant des radicaux hydroxyle sont des hydroxylacrylates et
(b) au cours de la seconde étape, on met en oeuvre les amines primaires ou secondaires en un excès molaire, par rapport aux radicaux isocyanate encore présents après la première étape et l'excès molaire est plus faible que la proportion molaire des hydroxylacrylates mis en oeuvre au cours de la première étape.

6. Utilisation des composés d'acrylate d'uréthanne durcissables par des rayonnements suivant la revendication 1 dans des revêtements et des matières ou masses durcissables par des rayonnements.

## Revendications (Revendications pour l'(les) Etat(s) contractant(s) suivant(s): ES)

1. Procédé de préparation de composés d'acrylate d'uréthanne contenant des radicaux amine et urée, durcissables par des rayonnements, par la réaction de diisocyanates ou de polyisocyanates avec des composés hydroxylés au cours d'une première étape et réaction subséquente des produits de la réaction avec des amines primaires ou secondaires, au cours d'une seconde étape, caractérisé en ce que
(a) au cours de la première étape, on utilise les radicaux isocyanate et les radicaux hydroxyle dans le rapport molaire de 1:0,55 à 1:0,99 et au moins 20% molaires des composés contenant des radicaux hydroxyle sont des hydroxylacrylates et
(b) au cours de la seconde étape, on met en oeuvre les amines primaires ou secondaires en un excès molaire, par rapport aux radicaux isocyanate encore présents après la première étape et l'excès molaire est plus faible que la proportion molaire des hydroxylacrylates mis en oeuvre au cours de la première étape.

2. Procédé suivant la revendication 1, caractérisé en ce que les composés d'acrylate d'uréthanne contiennent de 0,01 à 0,6 mole des radicaux amino secondaires ou tertiaires susmentionnés et 0,01 à 0,30 mole des radicaux urée, par rapport à 1 mole de radicaux isocyanates des diisocyanates ou des polyisocyanates mis en oeuvre pour la préparation des composés d'acrylate d'uréthanne.

3. Procédé suivant l'une quelconque des revendications 1 et 2, caractérisé en ce que les composés d'acrylate d'uréthanne contiennent des produits de réaction d'alcools au moins trihydroxylés avec au moins un composé de diisocyanate dans le rapport d'équivalence OH/NCO de 1:1,5 à 1:2,5, à titre de polyisocyanates.

4. Procédé suivant l'une quelconque des revendications 1 à 3, caractérisé en ce que les composés d'acrylate d'uréthanne contiennent des isocyanurates à titre de polyisocyanates.

5. Utilisation des composés d'acrylate d'uréthanne durcissables par des rayonnements suivant la revendication 1 dans des revêtements et des matières ou masses durcissables par des rayonnements.
